# EUROPEAN PATENT SPECIFICATION

(11) **EP 3 214 640 B1**
(45) Date of publication and mention of the grant of the patent: **15.01.2020**
(21) Application number: 15855011.1
(22) Date of filing: 22.10.2015
(51) Int. Cl.: H01L 21/3065

(54) **PLASMA ETCHING METHOD**
PLASMAÄTZVERFAHREN
PROCÉDÉ DE GRAVURE AU PLASMA

(30) Priority: 30.10.2014 JP 2014221423
(43) Date of publication of application: 06.09.2017
(73) Proprietor: Zeon Corporation, Tokyo 100-8246 (JP)
(72) Inventor: MATSUURA Goh, Tokyo 100-8246 (JP)
(74) Representative: Adam, Holger
(86) International application number: PCT/JP2015/079785
(87) International publication number: WO 2016/068004

(56) References cited:
- EP-A1- 1 014 433
- EP-A2- 1 619 267
- WO-A2-2011/047302
- JP-A- H10 140 151
- JP-A- 2006 074 013
- US-A1- 2005 026 430
- CHINZEI Y ET AL: "High aspect ratio SiO2 etching with high resist selectivity improved by addition of organosilane to tetrafluoroethyl trifluoromethyl ether", JOURNAL OF VACUUM SCIENCE AND TECHNOLOGY: PART A, AVS /AIP, MELVILLE, NY., US, vol. 18, no. 1, 1 January 2000 (2000-01-01), pages 158-165, XP012004907, ISSN: 0734-2101, DOI: 10.1116/1.582132

## Description

### TECHNICAL FIELD

The present invention relates to a plasma etching method that is implemented under plasma conditions using a process gas by selectively plasma-etching silicon oxide when silicon oxide and at least one material selected from the group consisting of silicon nitride, silicon, and an organic material are simultaneously subjected to etching.

### BACKGROUND ART

When producing a semiconductor device, a silicon compound film (e.g., SiO₂ film, Si₃N₄ (SiN) film, or SiC film) may be subjected to plasma etching (i.e., microfabrication) using a process gas so as to have the desired shape. When effecting plasma etching, the etching selectivity of the silicon compound film (processing target) with respect to a non-processing target silicon compound film and organic film formed on a single substrate is important.

Various plasma etching process gases have been proposed to meet the desired etching rate and etching selectivity ratio with respect to various types and combinations of the processing target silicon compound and the non-processing target silicon compound. For example, Non-Patent Literature 1 and Patent Literature 1 disclose a method that uses a fluorocarbon (e.g., C₄F6, C₄F₈, or CsFs) or a hydrofluorocarbon (e.g., CH₃F or C₅HF₇) as the process gas when etching a silicon oxide film.

WO 2011/047302 A2 relates to a method of cleaning and removing tin-containing contaminants from a process chamber used to manufacture electronic components.

EP 1 619 267 A2 relates to a process for removing carbon-containing residue from at least a portion of a surface of a substrate. It describes CH₃OCF₃ that is one of the hydrofluoroether (I) for the process gas.

EP 1 014 433 A1 describes a dry etching gas comprising an organic compound constituted of carbon, fluorine, hydrogen and oxygen and having 2-6 carbon atoms.

Y. Chinzei et al. discloses that fluorinated ethers containing hydrogen atoms especially CF₃OCHFCF₃ have already been used for etching SiO₂ in addition with compounds like Si(CH3)3H to increase the hydrogen proportion. ("High aspect ratio SiO2 etching with high resist selectivity improved by addition of organosilane to tetrafluoroethyl trifluoromethyl ether", Journal of Vacuum Science and Technology: Part A, AVS/AIP, Melville, NY, US, Vol. 18, No. 1, 1 January 2000, pages 158-165).

US 2005/026430 A1 discloses a method for plasma etching SiO₂ on the substrate using CH₂F₂, CH₃F and the like.

A fluorocarbon and a hydrofluorocarbon are normally mixed with a rare gas (e.g., argon) and oxygen when effecting plasma etching. This is because a thick plasma-polymerized film is formed on the substrate, and etching does not proceed when only a fluorocarbon or a hydrofluorocarbon is used as the process gas.

A rare gas is used to dilute the fluorocarbon or the hydrofluorocarbon, and oxygen is used to control the amount of CFx (wherein x is an integer from 1 to 3) that is a precursor for a plasma-polymerized film, and contributes to etching as active species. A polymerized film is formed on the substrate when the amount of CFx is large, and etching proceeds when the amount of CFx has become appropriate.

The amount of CFx is normally controlled (adjusted) by adjusting the flow rate of oxygen to be mixed. For example, the polymerization rate of silicon oxide gradually decreases as the flow rate of oxygen is gradually increased, and the flow rate region changes from the oxygen mixing flow rate region in which a polymerized film is preferentially formed, to the oxygen flow rate region in which silicon oxide is etched. When the etching rate of silicon oxide is sufficiently high with respect to silicon nitride, silicon, and an organic film (e.g., photoresist), for example, it is possible to etch silicon oxide with a high selectivity ratio.

A method that adds hydrogen gas may be used when it is desired to selectively etch silicon oxide with respect to silicon, for example. Specifically, since a fluorine radical produced from fluorocarbon gas etches silicon, the fluorine radical is trapped in the form of HF by adding hydrogen gas to prevent a situation in which silicon is etched.

However, it is difficult to use hydrogen gas from the viewpoint of safety, and it is more difficult to use hydrogen gas and oxygen gas at the same time.

A method that uses a hydrofluorocarbon that includes a hydrogen atom in the gas molecule may be used to solve the above problem.

However, a hydrofluorocarbon is easily polymerized as compared with a fluorocarbon, and it is very difficult to adjust the gas flow rate so that a sufficient etching rate is achieved while achieving high etching selectivity when etching is controlled by adding oxygen.

The etching rate of a silicon oxide film decreases, and the productivity achieved by the etching process deteriorates when a plurality of non-processing targets (e.g., silicon nitride, silicon, and organic film) are formed on the substrate, and conditions whereby a high selectivity ratio is achieved with respect to each material, are selected.

### CITATION LIST

### PATENT LITERATURE

Patent Literature 1: Japanese Patent No. 5440170 (US2010/0264116A1)

### NON-PATENT LITERATURE

Non-Patent Literature 1: Nishi et al., Handbook of Semiconductor Manufacturing Technology, Second Edition (2007), pp. 21-43

### SUMMARY OF INVENTION

### TECHNICAL PROBLEM

The invention was conceived in view of the above situation. An object of the invention is to provide a plasma etching method that is used to etch silicon oxide, and can implement high etching selectivity with respect to silicon nitride, silicon, and an organic material while achieving a sufficiently high etching rate without using oxygen and hydrogen.

### SOLUTION TO PROBLEM

In order to solve the above problem, the inventor conducted extensive studies with regard to a method that plasma-etches a silicon oxide film using various compounds as an etching gas. As a result, the inventor found that it is possible to achieve a sufficient etching rate while achieving a high etching selectivity ratio with respect to at least one non-etching target selected from silicon nitride, silicon, and an organic film, by utilizing a hydrofluoroether that satisfies specific conditions as the plasma etching gas (process gas). This finding has led to the completion of the invention.

One aspect of the invention provides the following plasma etching method (see (1) to (2)).
(1) A plasma etching method that is implemented under plasma conditions using a process gas, wherein at least one gas selected from a hydrofluoroether represented by a formula (I) and a rare gas are used as the process gas, the process gas comprising the rare gas in a ratio of 20 to 3,000 parts by volume based on 100 parts by volume of the hydrofluoroether represented by the formula (I) and the plasma etching method selectively etching silicon oxide when silicon oxide and at least one material selected from a group consisting of silicon nitride, silicon, and an organic material are simultaneously subjected to etching,

   CₘF₂ₘ₊₁-O-CH₂-R (I)

   wherein R represents a hydrogen atom or a fluoroalkyl group represented by CₙF₂ₙ₊₁, and m and n represent positive integers that satisfy 1≤m≤3 and 3≤(m+n)≤4.
(2) The plasma etching method according to (1), wherein the hydrofluoroether is at least one hydrofluoroether selected from the group consisting of 1,1,2,2,3,3,3-heptafluoropropyl methyl ether and heptafluoroisopropyl methyl ether.

### ADVANTAGEOUS EFFECTS OF INVENTION

The plasma etching method according to one aspect of the invention is used to etch silicon oxide, and can implement high etching selectivity with respect to silicon nitride, silicon, and an organic material while achieving a sufficiently high etching rate without using oxygen and hydrogen.

### DESCRIPTION OF EMBODIMENTS

The invention is described in detail below.

A plasma etching method according to one embodiment of the disclosure is implemented under plasma conditions using a process gas, wherein at least one gas selected from a hydrofluoroether represented by the formula (I) is used as the process gas.

The term "plasma etching" used herein refers to a technique that produces a glow discharge by applying a high-frequency electric field to a process gas to decompose the process gas into chemically active ions, electrons, and neutral species, and implements etching by utilizing chemical reactions between the active species and the etching target material, and reactions due to physical collision.

The plasma etching method according to one embodiment of the disclosure uses at least one compound selected from a hydrofluoroether represented by the following formula (I) (hereinafter may be referred to as "hydrofluoroether (I)") as the process gas.

CₘF₂ₘ₊₁-O-CH₂-R (I)

wherein R represents a hydrogen atom or a fluoroalkyl group represented by CₙF₂ₙ₊₁, and m and n represent positive integers that satisfy 1≤m≤3 and 3≤(m+n)≤4.

Specific examples of the hydrofluoroether (I) include CF₃-O-CH₂-C₂F₅, CF₃-O-CH₂-n-C₃F₇, CF₃-O-CH₂-i-C₃F₇, C₂F₅-O-CH₂-CF₃, C₂F₅-O-CH₂-C₂F₅, n-C₃F₇-O-CH₃, and i-C₃F₇-O-CH₃.

It is preferable that the hydrofluoroether (I) be at least one hydrofluoroether selected from the group consisting of n-C₃F₇-O-CH₃ (1,1,2,2,3,3,3-heptafluoropropyl methyl ether) and i-C₃F₇-O-CH₃ (heptafluoroisopropyl methyl ether) since a sufficient etching rate can be achieved while achieving a high etching selectivity ratio with respect to a non-etching target.

The hydrofluoroether used in the invention is characterized in that the hydrofluoroether does not include a carbon atom to which both a fluorine atom and a hydrogen atom are bonded (see the formula (I)). When the hydrofluoroether includes a carbon atom to which both a fluorine atom and a hydrogen atom are bonded, the hydrogen atom does not easily dissociate from the carbon atom as compared with a methyl group (-CH₃) and a methylene group (-CH₂-), and it is difficult to trap a free fluorine atom in a plasma environment in which etching is performed. When it is impossible to trap a free fluorine atom, the etching selectivity ratio decreases with respect to a silicon nitride film and a resist.

When the number of carbon atoms included in the hydrofluoroether molecule is small, it may be difficult to form a deposited film on a silicon nitride film or a photoresist, whereby the etching selectivity ratio may decrease. Therefore, the number of carbon atoms included in the hydrofluoroether molecule is preferably 4 or more, and more preferably 4 to 5. If the number of carbon atoms included in the hydrofluoroether molecule exceeds 5, the boiling point of the hydrofluoroether may increase, and it may be difficult to use the hydrofluoroether for etching.

The process gas used in connection with one embodiment of the invention may include the hydrofluoroether (I) and a rare gas in a mixed state. The rare gas may be at least one rare gas selected from the group consisting of helium, argon, neon, krypton, and xenon. A plasma etching process that can achieve a more sufficient etching rate while achieving a higher etching selectivity ratio with respect to a non-etching target, can be implemented by utilizing a rare gas together with the hydrofluoroether.(I) in a mixed state.

When the process gas includes a mixed gas including the hydrofluoroether (I) and a rare gas, it is preferably 1,000 to 2,500 parts by volume, and still more preferably 1,800 to 2,200 parts by volume, based on 100 parts by volume of the hydrofluoroether represented by the formula (I).

Each gas that is used as the process gas is normally transported independently in a state in which each gas is contained in a cylinder or the like, and provided to dry etching equipment (dry etching chamber). Each gas is introduced into the dry etching chamber when the valve of the cylinder has been opened, and subjected to a plasma so that dry etching proceeds.

The plasma etching method of the invention is characterized in that the plasma etching method selectively etches silicon oxide when silicon oxide, silicon nitride, silicon, and an organic film are simultaneously subjected to etching.

The term "silicon oxide" used herein refers to a silicon compound that includes an oxygen atom (e.g., SiO₂, SiOC, and SiOCH).

The term "silicon nitride" used herein refers to a silicon compound that includes a nitrogen atom (e.g., Si₃N₄(SiN) and SiCN).

The term "silicon" used herein includes crystalline silicon, polycrystalline silicon, amorphous silicon, and the like.

The term "organic material" used herein refers to a carbon-based material (e.g., photoresist and amorphous carbon).

The plasma etching method according to one embodiment of the invention may be implemented using a plasma etching apparatus. The plasma etching apparatus is not particularly limited. A known plasma etching apparatus may be used. Examples of the plasma etching apparatus include a helicon wave-type plasma etching apparatus, a high frequency induction-type plasma etching apparatus, a parallel plate-type plasma etching apparatus, a magnetron-type plasma etching apparatus, a microwave-type plasma etching apparatus, and the like. Among these, a parallel plate-type plasma etching apparatus, a high frequency induction-type plasma etching apparatus, and a microwave-type plasma etching apparatus are preferable since a high-density plasma can be easily generated. Note that other plasma etching apparatuses may also be used.

The plasma etching conditions are not particularly limited. Known etching conditions may be employed. For example, when a parallel plate-type high-frequency plasma etching apparatus is used that is designed so that the upper electrode (60 MHz) and the lower electrode (2 MHz) are placed at an interval of 35 mm, the electric power supplied to the upper electrode may be 200 to 2,000 W, and the electric power supplied to the lower electrode may be 0 to 600 W. The electric power supplied to the upper electrode and the electric power supplied to the lower electrode may be arbitrarily set within the above ranges.

It is preferable to control the temperature of the substrate using helium gas and a cooling device. The temperature of the substrate is preferably controlled to be within a range from -50 to +60°C, more preferably -20 to +40°C, and still more preferably -10 to +20°C. The pressure inside the reaction chamber included in the plasma etching apparatus is set to be within a range from 1 to 10 Pa.

### EXAMPLES

The invention is further described below by way of examples and comparative examples. Note that the invention is not limited to the following examples. The type of process gas, the etching conditions, and the like may be changed without departing from the scope of the invention.

### Example 1

A silicon substrate provided with a silicon oxide film (SiO₂), a silicon nitride film (Si₃N₄), a polycrystalline silicon film, and an ArF excimer laser photoresist coating film, was introduced into a plasma etching apparatus, and subjected to plasma etching. The etching rate was calculated from a change in the thickness of each film due to etching. When etching did not proceed, and a polymer film was formed, the thickness was divided by the etching time, and the resulting value was provided with a negative sign, and taken as the etching rate.

The etching selectivity ratio was calculated by dividing the etching rate of the silicon oxide film by the etching rate of each selection target film.

A parallel plate-type etching apparatus was used, and the upper electrode (60 MHz) and the lower electrode (2 MHz) were placed at an interval of 35 mm.

The electric power supplied to the upper electrode was 600 W, and the electric power supplied to the lower electrode was 240 W. The pressure inside the chamber was set to 2 Pa. The lower part was cooled at 0°C (cooling unit) for 60 seconds under a helium pressure of 1,000 Pa.

1,1,2,2,3,3,3-Heptafluoropropyl methyl ether (C₄H₃F₇O) (10 sccm) and argon (200 sccm) were introduced into the etching apparatus as the process gas.

The etching rate of the silicon oxide film was 258 nm/min, the etching rate of the silicon nitride film was -118 nm/min, the etching rate of the polycrystalline silicon film was -45 nm/min, and the etching rate of the photoresist was 9.6 nm/min.

The etching selectivity ratio of the silicon oxide film was infinity (∞) with respect to the silicon nitride film and the polycrystalline silicon, and was 27.0 with respect to the photoresist.

### Example 2

Etching was performed in the same manner as in Example 1, except that heptafluoroisopropyl methyl ether (C₄H₃F₇O) was used instead of 1,1,2,2,3,3,3-heptafluoropropyl methyl ether (C₄H₃F₇O).

The etching rate of the silicon oxide film was 278 nm/min, the etching rate of the silicon nitride film was -116 nm/min, the etching rate of the polycrystalline silicon film was -61 nm/min, and the etching rate of the photoresist was -54 nm/min. The etching selectivity ratio of the silicon oxide film was infinity with respect to the silicon nitride film, the polycrystalline silicon, and the photoresist.

### Comparative Example 1

Etching was performed in the same manner as in Example 1, except that 1,1,2,2-tetrafluoroethyl methyl ether (C₃H₄F₄O) was used instead of 1,1,2,2,3,3,3-heptafluoropropyl methyl ether (C₄H₃F₇O).

The etching rate of the silicon oxide film was 225 nm/min, the etching rate of the silicon nitride film was 266 nm/min, the etching rate of the polycrystalline silicon film was -39 nm/min, and the etching rate of the photoresist was -41 nm/min. The etching selectivity ratio of the silicon oxide film was 0.8 with respect to the silicon nitride film, and was infinity with respect to the polycrystalline silicon and the photoresist.

### Comparative Example 2

Etching was performed in the same manner as in Example 1, except that (1,2,2,2-tetrafluoroethyl) difluoromethyl ether (C₃H₂F₆O) was used instead of 1,1,2,2,3,3,3-heptafluoropropyl methyl ether (C₄H₃F₇O).

The etching rate of the silicon oxide film was 272 nm/min, the etching rate of the silicon nitride film was 267 nm/min, the etching rate of the polycrystalline silicon film was 10.4 nm/min, and the etching rate of the photoresist was 40 nm/min.

The etching selectivity ratio of the silicon oxide film was 1.0 with respect to the silicon nitride film, 26 with respect to the polycrystalline silicon, and 6.8 with respect to the photoresist.

### Comparative Example 3

Etching was performed in the same manner as in Example 1, except that perfluoro(n-propyl vinyl ether) (C₅F₁₀O) was used instead of 1,1,2,2,3,3,3-heptafluoropropyl methyl ether (C₄H₃F₇O).

The etching rate of the silicon oxide film was 423 nm/min, the etching rate of the silicon nitride film was 84 nm/min, the etching rate of the polycrystalline silicon film was 62 nm/min, and the etching rate of the photoresist was 202 nm/min.

The etching selectivity ratio of the silicon oxide film was 5.0 with respect to the silicon nitride film, 6.9 with respect to the polycrystalline silicon, and 2.1 with respect to the photoresist.

### Comparative Example 4

Etching was performed in the same manner as in Example 1, except that difluoromethyl 2,2,2-trifluoroethyl ether (C₃H₃F₅O) was used instead of 1,1,2,2,3,3,3-heptafluoropropyl methyl ether (C₄H₃F₇O).

The etching rate of the silicon oxide film was 239 nm/min, the etching rate of the silicon nitride film was 308 nm/min, the etching rate of the polycrystalline silicon film was -53 nm/min, and the etching rate of the photoresist was 23 nm/min.

The etching selectivity ratio of the silicon oxide film was 0.8 with respect to the silicon nitride film, infinity with respect to the polycrystalline silicon, and 10 with respect to the photoresist.

### Comparative Example 5

Etching was performed in the same manner as in Example 1, except that 1,1,2,2,2-pentafluoroethyl methyl ether (C₃H₃F₅O) was used instead of 1,1,2,2,3,3,3-heptafluoropropyl methyl ether (C₄H₃F₇O).

The etching rate of the silicon oxide film was 227 nm/min, the etching rate of the silicon nitride film was 293 nm/min, the etching rate of the polycrystalline silicon film was -46 nm/min, and the etching rate of the photoresist was -43 nm/min.

The etching selectivity ratio of the silicon oxide film was 0.8 with respect to the silicon nitride film, and infinity with respect to the the polycrystalline silicon and the photoresist.

### Comparative Example 6

Etching was performed in the same manner as in Example 1, except that hexalluoro-1,3-butadiene (C₄F₆) was used instead of 1,1,2,2,3,3,3-heptafluoropropyl methyl ether (C₄H₃F₇O), and oxygen was added at a flow rate of 5 sccm.

The etching rate of the silicon oxide film was 83 nm/min, the etching rate of the silicon nitride film was -20 nm/min, the etching rate of the polycrystalline silicon film was 8.6 nm/min, and the etching rate of the photoresist was 2.5 nm/min.

The etching selectivity ratio of the silicon oxide film was infinity with respect to the silicon nitride film, 9.6 with respect to the polycrystalline silicon, and 33 with respect to the photoresist.

### Comparative Example 7

Etching was performed in the same manner as in Comparative Example 6, except that octafluorocyclopentene (C₅F₈) was used instead of hexafluoro-1,3-butadiene (C₄F₆).

The etching rate of the silicon oxide film was 80 nm/min, the etching rate of the silicon nitride film was -38 nm/min, the etching rate of the polycrystalline silicon film was 29 nm/min, and the etching rate of the photoresist was -2.0 nm/min.

The etching selectivity ratio of the silicon oxide film was infinity with respect to the silicon nitride film, 2.8 with respect to the polycrystalline silicon, and infinity with respect to the photoresist.

The results obtained in the examples and the comparative examples are listed in Table 1. In Comparative Examples 6 and 7, a typical fluorine compound was used as the silicon oxide film etching gas. Since etching does proceed without the addition of oxygen when these compounds are used, the oxygen flow rate was changed, and conditions whereby the best selectivity ratio was obtained with respect to silicon nitride and silicon were selected.

The details of the fluorine compounds listed in Table 1 that were used as the component of the process gas, are shown below.
A: CF₃-CF₂-CF₂-O-CH₃
B: CH₃-O-CF(CF₃)₂
C: CHF₂-CF₂-O-CH₃
D: CF₃-CHF-O-CHF₂
E: CF₃-CF₂-CF₂-O-CF=CF₂
F: CHF₂-O-CH₂-CF₃
G: CH₃-O-CF₂-CF₃
H: C₄F₆
I: C₅F₈

**TABLE 1**

| | Gas | Etching rate (nm/min) | | | | Etching selectivity ratio of SiO₂ | | |
|---|---|---|---|---|---|---|---|---|
| | | SiO₂ | SiN | Si | Resist | SiN | Si | Resist |
| Example 1 | A | 258 | -118 | -45 | 9.6 | ∞ | ∞ | 27 |
| Example 2 | B | 278 | -116 | -61 | -54 | ∞ | ∞ | ∞ |
| Comparative Example 1 | C | 225 | 266 | -39 | -41 | 0.8 | ∞ | ∞ |
| Comparative Example 2 | D | 272 | 267 | 10.4 | 40 | 1 | 26 | 6.8 |
| Comparative Example 3 | E | 423 | 84 | 62 | 202 | 5 | 6.9 | 2.1 |
| Comparative Example 4 | F | 239 | 308 | -53 | 23 | 0.8 | ∞ | 10 |
| Comparative Example 5 | G | 227 | 293 | -46 | -43 | 0.8 | ∞ | ∞ |
| Comparative Example 6 | H | 83 | -20 | 8.6 | 2.5 | ∞ | 9.6 | 33 |
| Comparative Example 7 | I | 80 | -38 | 29 | -2 | ∞ | 2.8 | ∞ |

The following were confirmed from the results shown in Table 1.

In Examples 1 and 2, an etching selectivity ratio that is infinity or very high could be obtained with respect to a silicon nitride, silicon, and a photoresist while maintaining the etching rate of silicon oxide to be equal to or more than 200 nm/min. In Comparative Examples 1 to 5, a sufficiently high etching rate was achieved, but the selectivity ratio with respect to silicon nitride and the photoresist was small. In Comparative Examples 6 and 7, a high selectivity ratio was achieved, but the etching rate of silicon oxide was low.

According to the examples, since a high etching selectivity ratio of silicon oxide can be obtained with respect to silicon nitride, silicon, and a photoresist, it is possible to selectively etch silicon oxide when a silicon oxide film and a silicon nitride film are formed on the substrate, or a silicon oxide film and silicon are formed (provided) on the substrate, or when a silicon oxide film, a silicon nitride film, silicon, and a carbon-based material (e.g., photoresist) are formed (provided) on the substrate.

## Claims

1. A plasma etching method that is implemented under plasma conditions using a process gas, wherein at least one gas selected from a hydrofluoroether represented by a formula (I) and a rare gas are used as the process gas, the process gas comprising the rare gas in a ratio of 20 to 3,000 parts by volume based on 100 parts by volume of the hydrofluoroether represented by the formula (I) and the plasma etching method selectively etching silicon oxide when silicon oxide and at least one material selected from a group consisting of silicon nitride, silicon, and an organic material are simultaneously subjected to etching,
CₘF₂ₘ₊1-O-CH₂-R (I)
wherein R represents a hydrogen atom or a fluoroalkyl group represented by CₙF₂ₙ₊₁, and m and n represent integers that satisfy 1≤m≤3 and 3≤(m+n)≤4.

2. The plasma etching method according to claim 1, wherein the hydrofluoroether is at least one hydrofluoroether selected from a group consisting of 1,1,2,2,3,3,3-heptafluoropropyl methyl ether and heptafluoroisopropyl methyl ether.

## Patentansprüche

1. Plasmaätzverfahren, das unter Plasmabedingungen unter Verwendung eines Verfahrensgases durchgeführt wird, wobei wenigstens ein Gas, ausgewählt aus einem Hydrofluorether der Formel (I) und einem Edelgas, als das Verfahrensgas verwendet wird, wobei das Verfahrensgas das Edelgas in einem Verhältnisanteil von 20 bis 3.000 Volumenteilen, bezogen auf 100 Volumenteile des Hydrofluorethers, der durch die Formel (I) dargestellt wird, umfasst, und das Plasmaätzverfahren Siliciumoxid selektiv ätzt, wenn Siliciumoxid und wenigstens ein Material, ausgewählt aus der Gruppe, bestehend aus Siliciumnitrid, Silicium und einem organischen Material, gleichzeitig einem Ätzen unterworfen werden,
CₘF₂ₘ₊₁-O-CH₂-R (I)
worin R ein Wasserstoffatom oder eine Fluoralkylgruppe, dargestellt durch CₙF₂ₙ₊₁, darstellt, und m und n ganze Zahlen darstellen, die 1 ≤ m ≤ 3 und 3 ≤ (m+n) ≤ 4 genügen.

2. Plasmaätzverfahren gemäß Anspruch 1, wobei der Hydrofluorether wenigstens ein Hydrofluorether, ausgewählt aus der Gruppe, bestehend aus 1,1,2,2,3,3,3-Heptafluorpropylmethylether und Heptafluorisopropylmethylether, ist.

## Revendications

1. Procédé de gravure au plasma mis en oeuvre dans des conditions de plasma en utilisant un gaz de procédé, dans lequel au moins un gaz choisi parmi un hydrofluoroéther, représenté par une formule (I), et un gaz rare sont utilisés comme gaz de procédé, dans lequel le gas de procédé comprend le gaz rare dans un rapport de 20 à 3000 parties en volume sur la base de 100 parties en volume de l'hydrofluoroéther représenté par la formule (I), et le procédé de gravure au plasma grave sélectivement l'oxyde de silicium lorsque de l'oxyde de silicium et au moins un matériau choisi dans un groupe constitué du nitrure de silicium, du silicium et d'un matériau organique sont soumis simultanément à une gravure,
CₘF₂ₘ₊₁-O-CH₂-R (I)
dans laquelle R représente un atome d'hydrogène ou un groupe fluoroalkyle représenté par CₙF₂ₙ₊₁, et m et n représentent des entiers satisfaisant 1≤m≤3 et 3≤(m+n)≤4.

2. Procédé de gravure au plasma selon la revendication 1, dans lequel l'hydrofluoroéther est au moins un hydrofluoroéther choisi dans un groupe comprenant le 1,1,2,2,3,3,3-heptafluoropropylméthyléther et l'heptafluoroisopropylméthyléther.
